Europäisches Patentamt

**European Patent Office**

Office européen des brevets

(11) Publication number: **0 239 691 B1**

# EUROPEAN PATENT SPECIFICATION

(45) Date of publication of patent specification: **29.01.92**   (51) Int. Cl.⁵: **G01R 15/08**, G01R 15/12, G01R 1/20

(21) Application number: **86304175.2**

(22) Date of filing: **02.06.86**

(54) **Potentiometer for a voltage-measuring instrument.**

(30) Priority: **06.03.86 JP 49251/86**

(43) Date of publication of application:
**07.10.87 Bulletin 87/41**

(45) Publication of the grant of the patent:
**29.01.92 Bulletin 92/05**

(84) Designated Contracting States:
**AT BE CH DE FR GB IT LI LU NL SE**

(56) References cited:
**DE-A- 1 931 644**
**FR-A- 2 438 846**
**US-A- 3 262 049**

**IEEE TRANSACTIONS ON INSTRUMENTA-
TION AND MEASUREMENT, vol. IM-34, no. 2,
June 1985, pages 335-337, IEEE, New York,
US; G. RAMM et al.:
"Microprocessor-controlled binary inductive
voltage dividers"**

(73) Proprietor: **RIKEN DENSHI CO. LTD.**
**2801-3, Arima Aza Higashikohchi Takatsu-ku
Kawasaki City Kanagawa Prefecture(JP)**

(72) Inventor: **Yasunaga, Soichiro c/o Riken Den-
shi Co., Ltd.**
**2801-3, Arima Aza Higashikohchi Takatsu-ku
Kawasaki City§Kanagawa Prefecture(JP)**

(74) Representative: **Gordon, Michael Vincent et al
GILL JENNINGS & EVERY 53-64 Chancery
Lane
London WC2A 1HN(GB)**

## Description

This invention relates to a potentiometer for association with an instrument which measures dc or radio-frequency (RF) voltages and, more particularly, to a potentiometer comprising a variable resistor bank the resistance of which is adapted to be switched between a number of values.

A potentiometer of this kind is disclosed in US-A-4433287 (FR-A-2438846) and is shown in Fig. 6 of the accompanying drawings.

That known potentiometer, whose features are acknowledged in the preamble to the present main claim, comprises a fixed resistor Rf having a resistance value of 100r, a variable resistor Rv and an impedance transformer A1. The variable resistor Rv comprises a series combination R1 of resistors each having a high resistance value of 100r, a series combination R2 of resistors each having an intermediate resistance value of 10r, and a series combination R3 of resistors each having a low resistance value of r. When sliders are placed in arbitrary positions along the resistor groups R1-R3 having such different orders of magnitude of resistance values, i.e. when the slider of the group R1 is set at digit X, the slider of the group R2 is set at digit Y, and the slider of the group R3 is set at digit Z, the input voltage Vi is given by the relationship

$$Vi = V_o [100r + (X - 1)100r + Y10r + Zr]/100r$$
$$= V_o (X + 0.1Y + 0.01Z)$$

where $V_o$ is the output voltage.

Hence, the output voltage gives a full-scale indication, while the input voltage provides an indication magnified according to multiplier expressed by the three digits X, Y, Z and is measured. For example, at the illustrated position $Vi = 3.62V_o$.

When this potentiometer is employed, the full-scale reading of the voltage-measuring instrument can be widely varied at will in minute steps. Further, the set value can be read directly as the measured value. However, the potentiometer is bulky, because as many resistors as the steps of resistance are needed for each order of magnitude of resistance, as well as the associated switching circuit. Furthermore, the use of a rotary switch makes the potentiometer unsuitable for digital control.

In consideration of the foregoing, another potentiometer for a voltage-measuring instrument has been proposed in Japanese Patent Application No. 262983/1985, where banks of resistors are connected in series, according to the number of digits of the set multiplier, to form a variable resistor. Each bank of resistors consists of four resistors the resistances of which are respectively 1, 2, 4, 8 times a minimum resistance. A digital switch or the like produces a BCD (binary-coded decimal) signal to control the multiplier. However, this potentiometer does not allow the multiplier to be set less than the greatest order of magnitude of resistance. Therefore, a maximum voltage division ratio greater than 10:1 cannot be obtained.

Further examples of the use of binary or similar banks of resistors are disclosed in US-A-3262049 and IEEE Trans. on Instrumentation and Measurement, June 1985 pages 335-337.

An object of the present invention is to provide a potentiometer for a voltage-measuring instrument, which potentiometer is simple in structure and is capable of varying the voltage division ratio over a broader range.

According to the present invention there is provided a potentiometer for use in association with a voltage-measuring instrument having an input resistance Rs, where Rs = K x r, K being the voltage sensitivity of the voltage-measuring instrument and r being a minimum or unit resistance value;

comprising an impedance transformer having an input to which a voltage to be measured is applied, the transformer having a high input impedance and a low output impedance; a bank of resistors connected in series with the output of the transformer and to be connected in series with the voltage-measuring instrument and acting collectively as a variable resistor of value Rx; and multiplier-setting means for setting the value of a multiplier N, which is a number of at least two digits and is defined as the resistance value of the variable resistor bank divided by the unit resistance value r, such that the potentiometer delivers a voltage output corresponding to the thus-set value of N expressed in decimal notation;

characterised in that the resistors have respective resistance values r, 2r, 4r, 8r, ..., $2^{n-1}r$ or $10^0(r, 2r, 4r, 8r)$, $10^1(r, 2r, 4r, 8r)$, ..., $10^{n-1}(r, 2r, 4r, 8r)$; each of the resistors has a respective switch (S0, S1, S2, ..., Sn-1) connected in parallel therewith; and a switch control circuit is connected to an output of the multiplier-setting means to produce a signal for selectively opening and closing the switches in such a manner that the collective resistance value Rx of the variable resistor bank is adjusted to equal N x r - Rs.

Preferably, the switch control circuit comprises a compensating signal generator circuit producing an output corresponding to the value of K and further comprises a subtractor circuit which calculates N - K by subtracting the output of the compensating signal generator circuit from the output of the multiplier-setting means to produce said signal for selectively opening and closing the switches, normal operation being interrupted if the subtractor circuit detects that the difference $N - K$ is negative i.e. $N < K$, and the interruption of normal operation being accompanied by the issue of a warning signal.

Embodiments of the invention will now be described, by way of example, with reference to the accompanying drawings, in which:

Fig. 1 is a block diagram of a potentiometer in association with a voltage-measuring instrument, and constructed in accordance with the present invention;

Fig. 2(a) is a circuit diagram of a bank of resistors equipped with individual switches and having resistance values $r$, $2r$, $4r$, $8r$, ... $2^{n-1}r$, respectively, the bank of resistors being usable as a resistance bank shown in Fig. 1;

Fig. 2(b) is a circuit diagram of an alternative bank of resistors equipped with individual switches and having resistance values of $10^m.2^{n-1}r$, the bank of resistors being also usable as the resistance bank shown in Fig. 1;

Fig. 2(c) is a diagram of an equivalent circuit for the arrangement shown in Fig. 1;

Fig. 3 is a circuit diagram of a potentiometer with a voltage-measuring instrument, constructed in accordance with the invention, in which the resistors of the bank have resistance values $r$, $2r$, $4r$, ... $2^{n-1}r$, respectively, as in Fig. 2(a);

Fig. 4 is a diagram showing part of a modification of the potentiometer circuit of Fig. 3;

Fig. 5 is a circuit diagram of another potentiometer according to the invention, in which the resistors of a bank have resistances values $10^m.2^{n-1}r$ as in Fig. 2(b); and

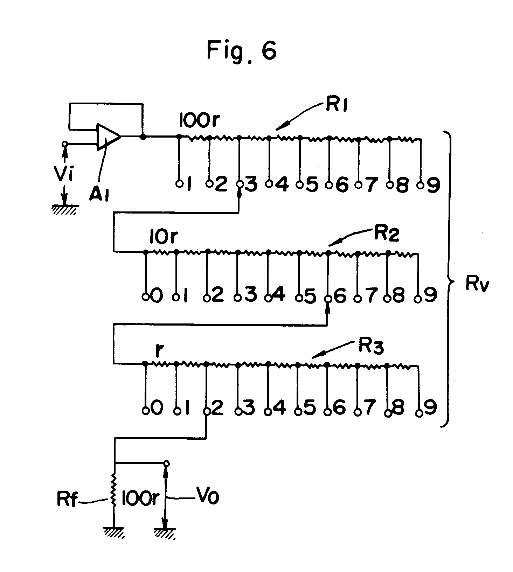

Fig. 6 is a circuit diagram of the above-described prior art potentiometer for use with a voltage-measuring instrument, with potentiometer slides at the indicated positions.

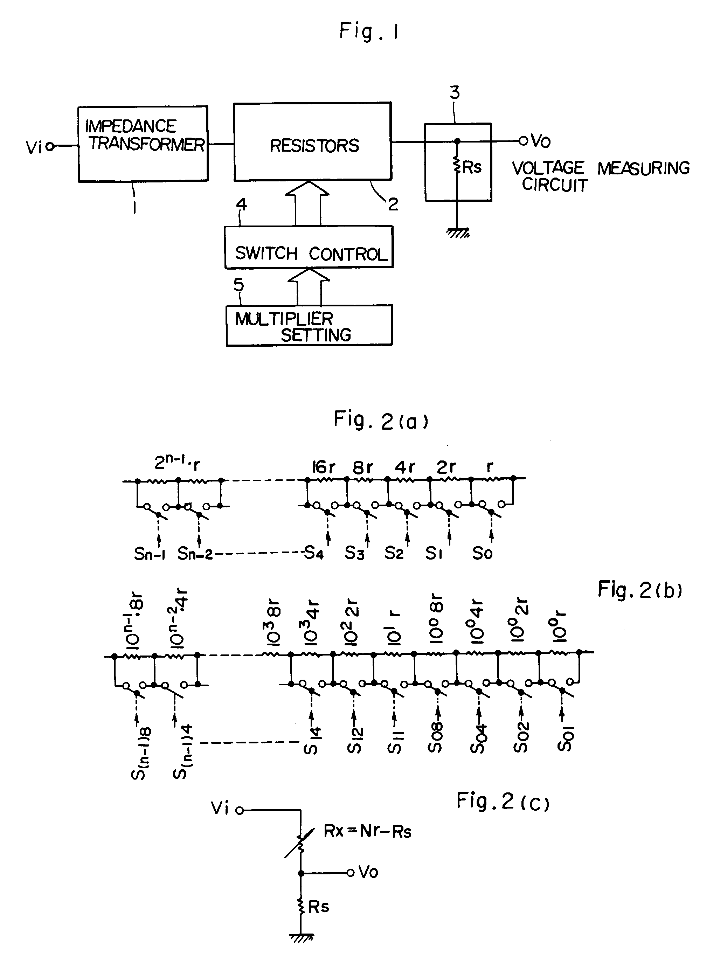

The concept of a potentiometer according to the present invention will first be described with reference to Fig. 1 of the drawings. The potentiometer comprises an impedance transformer 1, a bank of resistors 2 connected to the output of the transformer 1, and a voltage-measuring circuit 3 of, for example, a voltage measuring instrument such as a voltmeter, having an input resistance of $Rs = K \times r$, where $K$ is the voltage sensitivity of the circuit 3 and $r$ is the minimum, or unit, resistance value of the resistor bank 2. An unknown voltage $Vi$ to be measured is applied to the input of the transformer 1. The transformer 1, the resistor bank 2 and the voltage-measuring circuit 3 are connected in series. Each resistor of the bank has an individual switch connected in parallel therewith. The bank 2 can take the form shown in either Fig. 2(a) or Fig. 2(b). In Fig. 2(a), the resistors have resistance values $r$, $2r$, $4r$, $8r$, $16r$, ..., $2^{n-1}r$ and are equipped with corresponding switches $S_0$, $S_1$, $S_2$,

$S_3$, $S_4$, ..., $S_{n-1}$, respectively. In Fig.2(b), the resistors have resistance values $10^0$, $10^02r$, $10^04r$, $10^08r$, $10^1r$, $10^12r$, ..., $10^{n-1}8r$ and are equipped with corresponding switches $S_{01}$, $S_{02}$, $S_{04}$, $S_{08}$, $S_{11}$, $S_{12}$, ..., $S_{(n-1)8}$, respectively.

The potentiometer further includes a multiplier-setting circuit 5 for allowing the user to set a multiplier $N$ of two or more digits, the multiplier being expressed in decimal notation. The collective resistance value of the variable resistor formed by the resistor bank 2 is the resistance $r$ multiplied by the multiplier $N$. A signal indicating the multiplier $N$ is delivered from the circuit 5 in binary-coded decimal notation to a switch control circuit 4. Thus, the control circuit 4 selectively opens and closes the individual switches of the bank 2 according to the setting for $N$, in order that the resistance $Rx$ of the variable resistor bank is adjusted to a value equal to $N \times r - Rs$.

The multiplier-setting circuit 5 can be manually or automatically operated and delivers a signal indicating the multiplier $N$ ($= ... + 10^2N_2 + 10^1N_1 + 10^0N_0$, where $N_0$, $N_1$, $N_2$, and so on are natural numbers) in binary-coded decimal. The control circuit 4 delivers a signal coded so as to satisfy the relationship:

$$Rx = r \times N - Rs$$

The switches connected in parallel across their respective resistors are opened and closed individually by the output from the control circuit 4.

An equivalent circuit for the arrangement of Fig. 1 is shown in Fig. 2(c), where the output voltage $V_0$ from the voltage-measuring circuit 3 is equal to the voltage sensitivity $K$, i.e., $V_0 = K$, provided that the unknown voltage $Vi$ is measured after the multiplier $N$ has been so set that the output voltage $V_0$ is made equal to the full-scale voltage of the circuit, or the voltage sensitivity $K$. By also making use of the aforementioned relation $Rx = n \times r - Rs$, one gets:

$$Vi = V_0(Rs + Rx)/Rs - K(N \times r)/Rs$$
$$= K(N \times r)/(K \times r) = N$$
$$= ... 10^2N_2 + 10^1N_1 \_ 10^0N_0$$

That is, the multiplier $N$ which is set by the use of the setting circuit 5 to make the voltage-measuring circuit 3 give a full-scale indication will itself indicate the measured voltage $Vi$.

Where $N \times r - Rs < 0$, the set multiplier $N$ will not provide a full reading. In this case, a warning is used, or the multiplier $N$ presented on the display unit is maintained at a certain value.

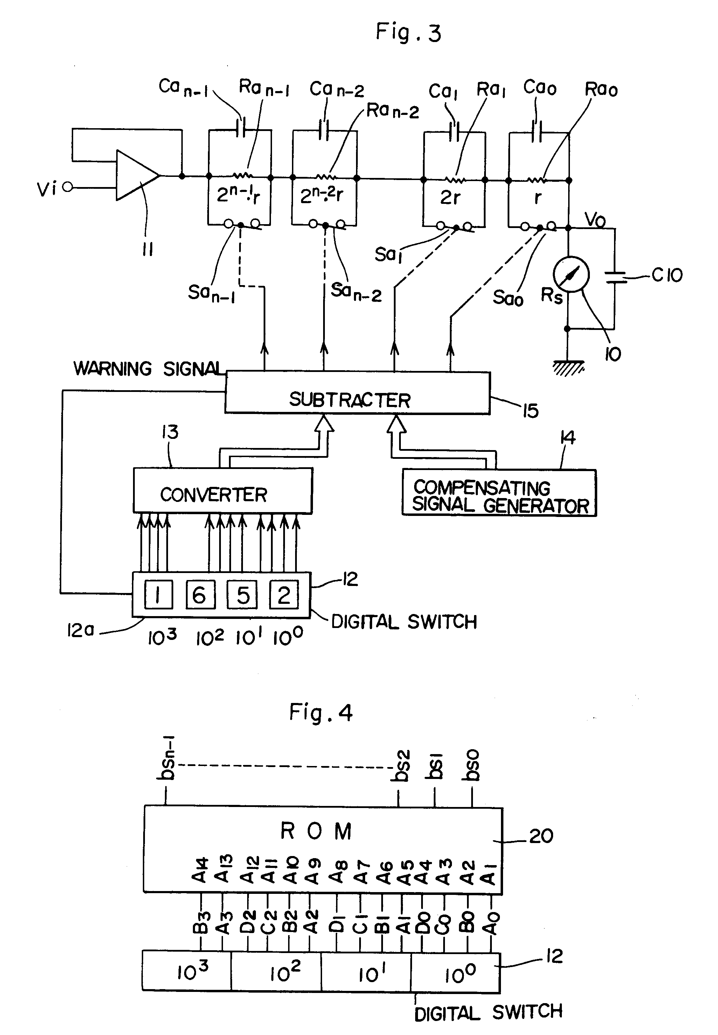

Referring next to Fig. 3, there is shown one embodiment of a potentiometer according to the invention. This potentiometer is associated with a voltmeter 10 having a voltage sensitivity K of 100mV and an input resistance (or fixed resistance) Rs of 100Ω. The potentiometer includes an impedance transformer 11 having a high input impedance and a low output impedance. A bank of resistors $R_{a0}$, $R_{a1}$, ..., $R_{an-1}$ which acts as a variable resistor is connected to the output of the impedance transformer 11. The resistor $R_{a0}$ has a minimum resistance value of r (= 1Ω, for example). The resistors $R_{a1}$, $R_{a2}$, ... $R_{an-1}$ have resistance values 2r, 4r,..., $2^{n-1}r$, respectively. Reed switches $S_{a0}$, $S_{a1}$, ..., $S_{an-1}$ are connected in parallel with the resistors $R_{a0}$, $R_{a1}$,..., $R_{an-1}$, respectively. Also, capacitors $C_{a0}$, $C_{a1}$, ..., $C_{an-1}$ for compensating high frequency characteristics are connected in parallel with the resistors $R_{a0}$, $R_{a1}$, ..., $R_{an-1}$, respectively. Similarly, a capacitor $C_{10}$ is connected in parallel with the voltmeter 10. A digital switch 12 is used to set the multiplier N as a four digit number. That is, any resistance value set by the user is the unit resistance value r multiplied by the multiplier N. The switch 12 has a display portion 12a on which the set multiplier N is displayed in decimal notation. A signal indicating the multiplier is delivered in BCD form to a converter circuit 13 for converting the BCD signal into a form indicating r, 2r, 4r, 8r, ..., $2^{n-1}r$. The output signal from the converter circuit 13 corresponds to the previously-set multiplier N. A compensating signal generator circuit 14 produces a signal corresponding to K = 100. This signal takes the same form as the output from the converter 13. A subtractor circuit 15 produces a signal corresponding to the difference (N- K) between the output signal from the converter circuit 13 and the output signal from the compensating signal generator circuit 14 to selectively open the switches $S_{a0}$, $S_{a1}$, ..., $S_{an-1}$. If the relationship N < K should occur and be detected by the subtractor, the subtractor circuit causes one or more of the following operations: (1) it issues a warning signal to prevent the occurrence of errors; (2) the set multiplier in decimal notation is not displayed on the display portion 12a of the digital switch 12, nor does the switch produce the corresponding output signal; and (3) the resistance Rx of the variable resistor bank is set equal to zero. In this way, normal operation is interrupted.

The potentiometer constructed as described above operates as follows. The voltmeter 10 with which the potentiometer is associated has such a sensitivity that the application of 100 mV produces a full-scale indication. It is assumed that the multiplier N is set equal to 1652 (as shown in Fig. 3) by means of the digital switch 12, under the condition that a radio-frequency signal Vi = 1.652V = 1652mV is applied. The multiplier number in decimal notation is converted into a signal corresponding to r, 2r, 4r, 8r, ..., $2^{n-1}r$ by the converter circuit 13, and the signal is supplied to the subtractor circuit 15. Then, the subtractor circuit produces a signal corresponding to the difference between the output signal from the converter circuit 13 and the output signal from the compensating signal generator circuit 14. The signal from the compensation circuit 14 will indicate "100". Thus, the output signal from the subtractor circuit 15 is so coded as to correspond to $(10^3 \times 1 + 10^2 \times 6 + 10^1 \times 5 + 10^0 \times 2) - 100 = 1552$. The values of the resistors $R_{a0}$ to $R_{an-1}$ are obtained by multiplying by Ω. Since Rx = 1552Ω and Rs = K x r = 100Ω, the voltage applied to the voltmeter is given by

$$V_0 = \frac{Rs}{Rx + Rs} Vi$$
$$= \frac{100}{1552+100} \times 1652mV$$
$$= \frac{100}{1652} \times 1652mV$$
$$= 100mV$$

Hence, the application of 1652mV causes the voltmeter to indicate a full-scale indication, the sensitivity of the voltmeter being 100mV. If the multiplier N set using the switch 12 is less than the voltage sensitivity 100mV of the voltmeter 10 (N < 100), then the subtractor circuit 15 issues a warning, simply makes a voltage measurement while maintaining Rx at zero, or makes the switch 12 inoperative.

If the sensitivity of the voltmeter 10 is set to 50mV, the compensating signal generator circuit 14 produces a signal corresponding to the modified value K = 50, so that Rs = K x r = 50Ω. When the sensitivity of the voltmeter 10 is set to 200 mV and the minimum resistance r is 10Ω, RS = 200 x 10Ω = 2KΩ.

The converter circuit 13, the compensating signal generator circuit 14, and the subtractor circuit 15 shown in Fig. 3 are combined into a unit for selectively opening the switches. In particular, as shown in Fig. 4, the contents of a ROM (read-only memory) 20 are addressed by the output signal from the digital switch 12. The data from the subtractor circuit 15 are stored in the ROM 20. Where Rx < Rs as mentioned previously, data resulting in Rx = 0 are stored in the ROM 20. For example, all of the bits $b_{s0}$ - $b_{sn-1}$ are set to 0. Depending on the kinds of the switches $S_{a0}$ - $S_{an-1}$ and their associated circuitry, all of the bits may be set to 1. In this way, the voltmeter is caused to read directly the input voltage Vi; otherwise, special data are stored in the ROM to produce a warning signal.

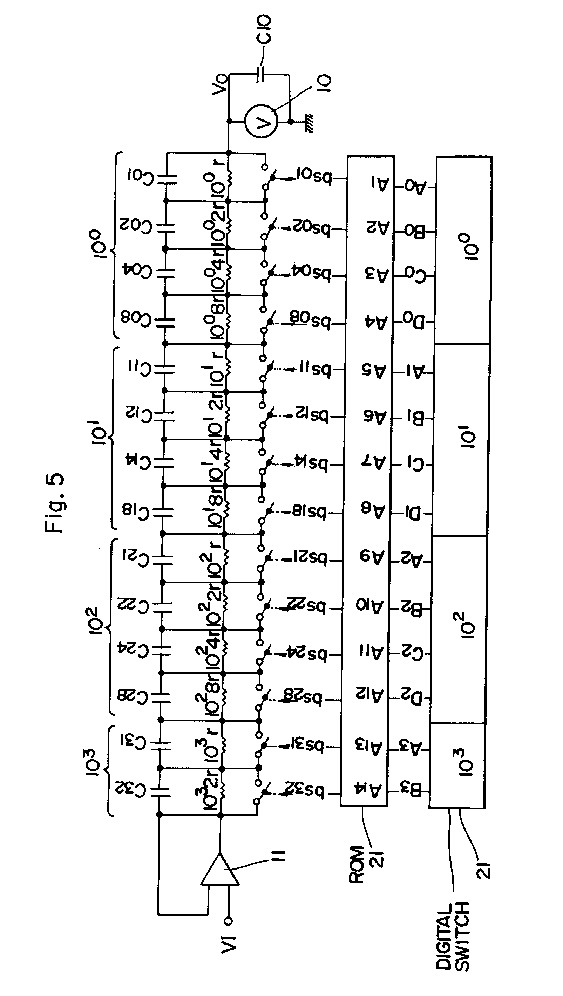

In the above example, the resistors have resistance values r, 2r, 4f, 8r, ..., $2^{n-1}$r. Referring to Fig. 5 the resistors here have resistance values $10^0$r, $10^0$2r, $10^0$4r, $10^0$8r, $10^1$r, $10^1$2r, $10^1$4r, $10^1$8r, $10^2$r, ... $10^3$2r. The collective resistance value Rx of the variable resistor bank is adjusted to N x r - Rs by a switch control circuit. Data used for this adjustment may be stored in a ROM 21. The switch control circuit can consist of a compensating signal generator circuit and a subtractor circuit in the same manner as the control circuit shown in Fig. 3.

The multiplier-setting circuit can consist of an automatic control circuit or the like which produces an output signal for setting the multiplier N in such a way that the output voltage $V_0$ from the voltage-measuring circuit automatically gives a full-scale indication. The control circuit also displays the set value.

As described thus far, the potentiometer of the present invention is made up of a smaller number of voltage-dividing resistors and occupies less space than the conventional rotary switch-type potentiometer. Furthermore, the multiplier can be easily switched between different values under remote control. In addition, the collective resistance value of the variable resistor can be readily adjusted automatically. Also, the multiplier can be set over a range beyond the voltage sensitivity range of a voltage-measuring circuit. Therefore, a voltage division ratio can be obtained over a greatly extended range, resulting in a broader measuring range. If the fixed input resistance and the sensitivity of the voltage-measuring circuit, such as a voltmeter, have to be modified, all that is needed is a modification of the subtrahend; it is not necessary to adjust the variable resistor bank itself.

## Claims

1. A potentiometer for use in association with a voltage-measuring instrument (10) having an input resistance Rs, where Rs = K x r, K being the voltage sensitivity of the voltage-measuring instrument and r being a minimum or unit resistance value;

   comprising an impedance transformer (1; 11) having an input to which a voltage to be measured is applied, the transformer having a high input impedance and a low output impedance; a bank of resistors (2) connected in series with the output of the transformer and to be connected in series with the voltage-measuring instrument and acting collectively as a variable resistor of value Rx; and multiplier-setting means (5; 12, 13) for setting the value of a multiplier N, which is a number of at least two digits and is defined as the resistance value of the variable resistor bank divided by the unit resistance value r, such that the potentiometer delivers a voltage output corresponding to the thus-set value of N expressed in decimal notation;

   characterised in that the resistors have respective resistance values r, 2r, 4r, 8r, ..., $2^{n-1}$r or $10^0$(r, 2r, 4r, 8r), $10^1$(r, 2r, 4r, 8r), ..., $10^{n-1}$(r, 2r, 4r, 8r); each of the resistors has a respective switch (S0, S1, S2, ..., Sn-1) connected in parallel therewith; and a switch control circuit (4; 14, 15) is connected to an output of the multiplier-setting means to produce a signal for selectively opening and closing the switches in such a manner that the collective resistance value Rx of the variable resistor bank is adjusted to equal N x r - Rs.

2. A potentiometer as claimed in claim 1, characterised in that the multiplier-setting means comprises a digital switch (12) which is operable manually.

3. A potentiometer as claimed in claim 1, characterised in that the multiplier-setting means is an automatic control circuit the output signal of which is automatically varied according to the measured voltage.

4. A potentiometer as claimed in any preceding claim, characterised in that the switch control circuit comprises a compensating signal generator circuit (14) producing an output corresponding to the value of K and further comprises a subtractor circuit (15) which calculates N - K by subtracting the output of the compensating signal generator circuit (14) from the output of the multiplier-setting means (12, 13) to produce said signal for selectively opening and closing the switches.

5. A potentiometer as claimed in claim 4, characterised in that normal operation is interrupted if the subtractor circuit (15) detects that the difference N - K is negative i.e. N < K.

6. A potentiometer as claimed in claim 5, characterised in that the interruption of normal operation is accompanied by the issue of a warning signal.

## Revendications

1. Potentiomètre à utiliser en association avec un instrument (10) de mesure de tension ayant une résistance d'entrée Rs, où Rs = K x r, K étant la sensibilité à la tension de l'instrument de mesure de tension et r étant une valeur de résistance minimale ou unité ;

comportant un transformateur d'impédance (1 ; 11) ayant une entrée à laquelle une tension à mesurer est appliquée, le transformateur ayant une impédance d'entrée élevée et une impédance de sortie basse ; une batterie de résistances (2) connectée en série avec la sortie du transformateur et destinée à être connectée en série avec l'instrument de mesure de tension, et agissant ensemble à la manière d'une résistance variable de valeur Rx ; et des moyens (5 ; 12, 13) de réglage de multiplicateur destinés à régler la valeur d'un multiplicateur N, qui est un nombre d'au moins deux chiffres et qui est définie comme étant la valeur de résistance de la batterie de résistances à valeur variable divisée par la valeur de résistance unité r, afin que le potentiomètre délivre une tension de sortie correspondant à la valeur ainsi réglée de N exprimée en notation décimale ;

caractérisé en ce que les résistances ont des valeurs de résistance respectives $r$, $2r$, $4r$, $8r$, ..., $2^{n-1}r$ ou $10^0(r, 2r, 4r, 8r)$, $10^1(r, 2r, 4r, 8r)$, $10^{n-1}(r, 2r, 4r, 8r)$ ; chacune des résistances comporte un interrupteur respectif (S0, S1, S2, ..., Sn-1) connecté en parallèle avec elle ; et un circuit (4 ; 14, 15) de commande d'interrupteurs est connecté à une sortie des moyens de réglage du multiplicateur pour produire un signal destiné à ouvrir et fermer sélectivement les interrupteurs de manière que la valeur de résistance collective Rx de la batterie de résistances à valeur variable soit ajustée pour être égale à $N \times r - Rs$.

2. Potentiomètre selon la revendication 1, caractérisé en ce que les moyens de réglage du multiplicateur comprennent un commutateur numérique (12) qui peut être manoeuvré à la main.

3. Potentiomètre selon la revendication 1, caractérisé en ce que les moyens de réglage du multiplicateur comprennent un circuit de commande automatique dont le signal de sortie est modifié automatiquement en fonction de la température mesurée.

4. Potentiomètre selon l'une quelconque des revendications précédentes, caractérisé en ce que le circuit de commande d'interrupteurs comporte un circuit (14) de générateur de signal de compensation produisant un signal de sortie correspondant à la valeur de K, et comporte en outre un circuit soustracteur (15) qui calcule N - K en soustrayant le signal de sortie du circuit (14) de générateur de signal de compensation du signal de sortie des moyens (12, 13) de réglage du multiplicateur pour produire ledit signal destiné à ouvrir et fermer sélectivement les interrupteurs.

5. Potentiomètre selon la revendication 4, caractérisé en ce qu'un fonctionnement normal est interrompu si le circuit soustracteur (15) détecte que la différence N - K est négative, c'est-à-dire N < K.

6. Potentiomètre selon la revendication 5, caractérisé en ce que l'interruption du fonctionnement normal est accompagnée de la délivrance d'un signal d'avertissement.

**Patentansprüche**

1. Potentiometer zur Verwendung in Verbindung mit einem Spannungsmeßinstrument (10), das einen Eingangswiderstand Rs besitzt, worin Rs = K x r und K die Spannungsempfindlichkeit des Spannungsmeßinstrumentes und r ein Minimum oder einen Einheitswiderstandswert darstellen;

umfassend einen Impedanzwandler (1;11), der einen Eingang besitzt, an den eine zu messende Spannung angelegt ist, und wobei der Wandler eine hohe Eingangs-Impedanz und eine niedrige Ausgangs-Impedanz besitzt; eine Bank von Widerständen (2), die in Reihen mit dem Ausgang des Wandlers und in Reihen mit dem Spannungsmeßinstrument geschaltet sind und gemeinsam als ein variabler Widerstand des Wertes Rx wirken; und ein Multiplizierschaltungsmittel (5;12,13) zum Einstellen des Wertes eines Multiplikators N, der eine Zahl mit mindestens zwei Ziffern darstellt und als Widerstandswert der variablen Widerstandsbank geteilt durch den Einheitswiderstandswert r derart gebildet wird, daß der Potentiometer einen Spannungsausgang liefert, der dem so eingestellten N-Wert, ausgedrückt in dezimaler Einheit, entspricht, dadurch gekennzeichnet, daß die Widerstände entsprechende Widerstandswerte $r$, $2r$, $4r$, $8r$, ...., $2^{n-1}r$ oder $10^0 (r, 2r, 4r, 8r)$, $10^1 (r, 2r, 4r, 8r)$, ....., $10^{n-1} (r, 2r, 4r, 8r)$ besitzen, wobei jeder Widerstand einen entsprechenden Schalter (S0, S1, S2 Sn-1) besitzt, die parallel dazu geschaltet sind, und daß eine Schaltersteuerungsschaltung (4; 14, 15) mit einem Ausgang des Multiplizierschaltungsmittels verbunden ist, um ein Signal zum selektiven Öffnen und Schließen der Schalter auf solche Weise zu erzeugen, daß die gemeinsamen Widerstandswerte Rx der variablen Widerstandsbank gleich Nxr - Rs eingestellt werden.

2. Potentiometer nach Anspruch 1, dadurch gekennzeichnet, daß das Multiplizierschaltungsmittel einen Digitalschalter (12) umfaßt, der manuell betätigbar ist.

3. Potentiometer nach Anspruch 1, dadurch gekennzeichnet, daß das Multiplizierschaltungsmittel eine automatische Steuerungsschaltung darstellt, deren Ausgangssignal automatisch entsprechend der gemessenen Spannung verändert wird.

4. Potentiometer nach irgendeinem der vorstehenden Ansprüche, dadurch gekennzeichnet, daß die Schaltersteuerungsschaltung eine Kompensationssignalgeneratorschaltung (14) umfaßt, die einen Ausgang erzeugt, der dem Wert von K entspricht und ferner eine Subtraktionsschaltung (15) umfaßt, die N - K errechnet, durch Abziehen des Ausgangs der Kompensationssignalgeneratorschaltung (14) vom Ausgang des Multiplizierschaltungsmittels (12,13), um das Signal zum selektiven Öffnen und Schließen der Schalter zu erzeugen.

5. Potentiometer nach Anspruch 4, dadurch gekennzeichnet, daß ein normaler Betrieb unterbrochen wird, falls die Subtrahierschaltung (15) feststellt, daß die Differenz N - K negativ ist, d.h. N < K.

6. Potentiometer nach Anspruch 5, dadurch gekennzeichnet, daß die Unterbrechung des Normalbetriebs begleitet wird durch die Abgabe eines Warnsignals.

Fig. 1

IMPEDANCE TRANSFORMER

RESISTORS

Vi

Rs

Vo

VOLTAGE MEASURING CIRCUIT

SWITCH CONTROL

MULTIPLIER SETTING

Fig. 2(a)

$2^{n-1} \cdot r$    16r   8r   4r   2r   r

$S_{n-1}$   $S_{n-2}$ ———— $S_4$   $S_3$   $S_2$   $S_1$   $S_0$

Fig. 2(b)

$10^{n-1} \cdot 8r$   $10^{n-2} \cdot 4r$   $10^3 8r$   $10^3 4r$   $10^2 2r$   $10^1 r$   $10^0 8r$   $10^0 4r$   $10^0 2r$   $10^0 r$

$S_{(n-1)8}$   $S_{(n-1)4}$ ———— $S_{14}$   $S_{12}$   $S_{11}$   $S_{08}$   $S_{04}$   $S_{02}$   $S_{01}$

Fig. 2(c)

Vi

$Rx = Nr - Rs$

Vo

Rs

## Fig. 3

WARNING SIGNAL

SUBTRACTER 15

CONVERTER 13

COMPENSATING SIGNAL GENERATOR 14

DIGITAL SWITCH 12

$10^3$ $10^2$ $10^1$ $10^0$

12a

## Fig. 4

ROM 20

DIGITAL SWITCH 12

$10^3$ $10^2$ $10^1$ $10^0$

Fig. 5

EP 0 239 691 B1

# Fig. 6